(19) Europäisches Patentamt
European Patent Office
Office européen des brevets

(11) **EP 1 394 972 B1**

(12) **EUROPEAN PATENT SPECIFICATION**

(45) Date of publication and mention
of the grant of the patent:
**01.03.2006 Bulletin 2006/09**

(51) Int Cl.:
*H04B 15/02* (2006.01)    *H04B 1/40* (2006.01)
*H03K 7/08* (2006.01)

(21) Application number: **02425547.3**

(22) Date of filing: **02.09.2002**

(54) **High speed interface for radio systems**

Hochgeschwindigkeitschnittstelle für Funkanlagen

Interface haute vitesse pour systèmes radio

(84) Designated Contracting States:
**DE FR GB IT**

(43) Date of publication of application:
**03.03.2004 Bulletin 2004/10**

(73) Proprietor: **STMicroelectronics S.r.l.**
**20041 Agrate Brianza (Milano) (IT)**

(72) Inventors:
• **Boarin, Gianluigi**
**27011 Belgioioso PV (IT)**
• **Adduci, Francesco**
**20161 Milano (IT)**
• **Oddicini, Mattia**
**15010 Montaldo Bormida AI (IT)**
• **Crudo, Salvatore Matteo**
**20133 Milano (IT)**

(74) Representative: **Mittler, Enrico et al**
**Mittler & C. s.r.l.,**
**Viale Lombardia, 20**
**20131 Milano (IT)**

(56) References cited:
**EP-A- 0 163 313**    **WO-A-02/067450**
**GB-A- 2 326 036**    **US-B1- 6 275 526**

**Description**

The present invention relates to a high speed interface for radio systems, in particular to a synchronous serial digital interface for car radio

In radio applications the electro magnetic interference is a very important issue.

Further, in new systems on chip is required very high scale integration, in a smaller and smaller area, embedding many functions on CMOS technology In order to cover a wide range of different customer requirements, and keep at the same time a low number of dedicated chip, device modular approach is a key point for market offer.

Moreover, a radio system has to deal with tiny analogue signal coming from antennas and turner front-ends

Literature shows a huge variety of digital interfaces, which should reduce as much as possible electro magnetic emission. Further, none of them are specifically dedicated to dual or multi tuner radio receiver, where switching noise gives very significant contribution to performance degradation.

WO 02/067450 disclosed an interface according to the precharacterizing part of amended claim 1

GB 2326036 discloses a pulse width modulated clock generator producing reduced EMI. The mark-space ratio of the clock signal is modulated by a lamp so that the harmonics associated with clock switching transients are spread out and the maximum harmonic amplitude is reduced.

In view of the state of the art described, it is an object of the present invention to provide a high speed interface for radio systems and in particular for car radio systems.

According to the present invention, such object is achieved by a synchronous serial digital interface for at least dual radio receiver systems as defined in claim 1.

Furthermore according to the present invention, such object is achieved by an antenna diversity system for radio systems comprising a synchronous serial digital interface according to claim 1.

Thanks to the present invention is possible to have an interface that copes with systems where low emission, high speed, and high data transfer efficiency live together The characteristic of the present interface give very low electro magnetic emission, thus leading to a very quiet interface, which can be freely integrated without bothering about noise when high rate data transfer operates.

The features and the advantages of the present invention will be made more evident by the following detailed description of a particular embodiment, illustrated as a non-limiting example in the annexed drawings, wherein:

Figure 1 shows a block scheme of a dual radio receiver system according to the present invention;
Figure 2 shows the timing diagram of the transfer data;
Figure 3 shows chip comprising an interface according to the present invention.

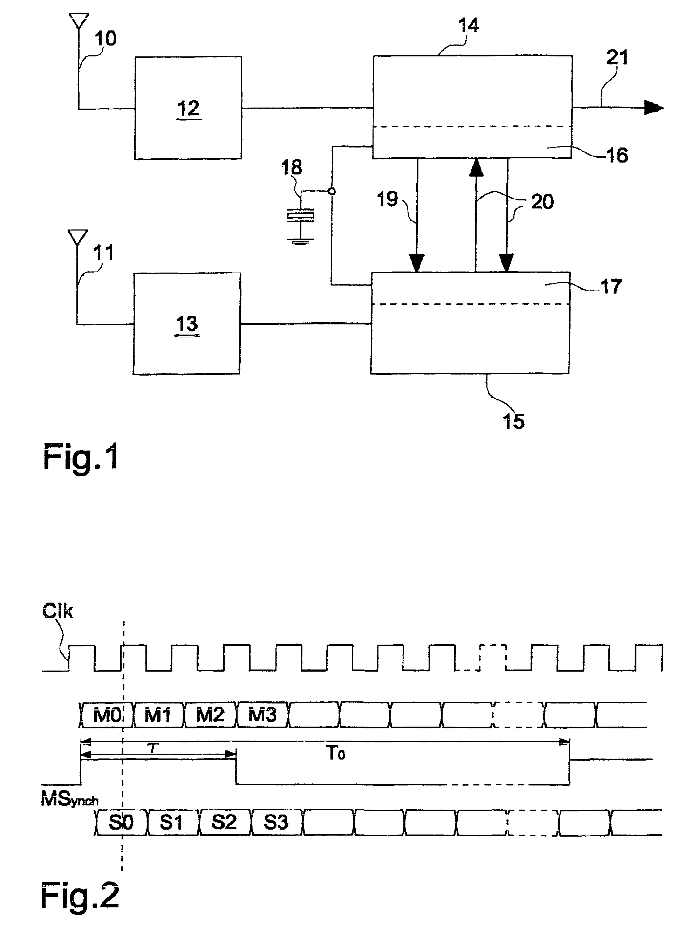

The dual radio receiver system shown in figure 1, include two antennas 10 and 11 connected respectively to two turner front end 12 and 13, which from antennas 10 and 11 takes the RF (radio frequency) and convert it to IF (intermediate frequency) of 10.7MHz.

The IF signals, coming from the turner front end 12 and 13 are supplied respectively to two digital signal processors (DSP) 14 and 15.

The digital signal processors 14 and 15 communicate between them by means of two synchronous serial digital interfaces 16 and 17 (respectively), according to present invention The digital interface 16 is to be considered as a master and the digital interface 17 is to be considered as a slave They use a single clock signal generated by the same crystal quartz 18 The master digital interface 16 supply to the slave digital interface 17 a synchronisation signal 19, and the digital interfaces 16 and 17 exchange their data in bidirectional way by means of the signals 20. The whole system has only one audio output 21.

To enhance the quality of FM stations, tuner diversity can be adopted, giving an impressive improvement to the reception even in adverse environments, where multi-path and fading effects are dominants, as well as suppressing strong adjacent channels.

According to the present invention two sets of turner front end 12 and 13 and digital signal processors 14 and 15 are connected together, to implement an antenna diversity system.

Signals coming from separate antennas are processed in each device, and then are exchanged between them by means of the digital interfaces 16 and 17. In this case with a proper algorithm is possible enhances quality of reception. The converted IF signals are gathered into the Master device which first analyse field strength of each of them: the one with insufficient field strength is dropped, and the other chosen; else, if both have significant strength, a proper amplitude and phase correction is performed before sum them up. That leads to an antennas beam forming, which is typically used in Radio Base Band Stations.

On the other hand the data exchange is at very high rate, very close to IF and FM bandwidth, hence the request to reduce as much as possible radiation from the digital interfaces 16 and 17 is raised. The digital interfaces 16 and 17 do not exchange a high speed clock, but only a synchronisation signal 19 is used to permits data rebuild in the slave interface.

The data rate is, in the present case, 1/256 the crystal frequency, i.e. 74.1MHz/256 = 289.45kHz. Word length is 16bits, and 2 words are transmitted and/or received at a time, which leads to a bit rate for each channel of 289.45kHz*16*2 = 9.2625Mbit/sec. The synchronisation signal synchronises the digital interfaces 16 and 17 on its rising edge. Whereas in slave mode the synchronisation signal is received and extracted to internally initialise the blocks and send synchronously back the slave data stream.

Master interface 16 does not need send bit clock to slave, since both interfaces run off same crystal so instantly they are at the exactly same frequency, and slave only needs to recover the proper phase, to latch data in. The same clock phase is used by the slave to send out its own data.

Referring now to figure 2, the master interface 16 sends data Mi with a bit clock Ck running at 9.2625MHz, and a synchronisation signal MSynch with a rising edge (the synchronisation will be on the slave chip upon the rising edge of it) at the synchronisation rate Fs or period $T_0$. At the rising edge of the synchronisation signal start the transmission of data from the master interface 16 toward the slave interface 17.

The duty cycle $D = \tau/T_0$ of the synchronisation signal MSynch can be adjusted among different values, at which the interference around the IF frequency (10.7MHz) is minimised.

The slave interface 17 is such that the master interface 16 can capture the slave Si bit at the rising edge of the master bit clock Ck just after the one which has previously generated the master Mi bit.

Data line has the maximum frequency of 9.26 MHz/2 = 4.63 MHz, when transmitting or receiving a sequence of 101010..., in general it can be assumed data sequence being random, thus spreading its frequency spectrum over the band.

The synchronisation signal gives the start of the frame, and the serial interface uses one on its edges to extract the synchronisation and to recover from serial to parallel format the data upon reception. One choice of the synchronisation signal is a square wave with a duty cycle $D = \tau/T_0$, where $T_0$ is the period and $\tau$ is the time where the synchronisation signal is on.

The Fourier series expansion of a generic periodic function with period $T_0$ is:

$$F(t) = A_0 + \sum A_n \cos\left(2\pi n \frac{t}{T_0}\right) + \sum B_n \cos\left(2\pi n \frac{t}{T_0}\right)$$

where

$$A_0 = \frac{1}{T_0} \int_{-T_0/2}^{T_0/2} F(t)\,dt$$

$$A_n = \frac{1}{T_0} \int_{-T_0/2}^{T_0/2} F(t)\cos\left(2\pi n \frac{t}{T_0}\right) dt$$

$$B_n = \frac{1}{T_0} \int_{-T_0/2}^{T_0/2} F(t)\sin\left(2\pi n \frac{t}{T_0}\right) dt$$

So in our analysis where F(t) is a square wave with duty cycle $D = \tau/T_0$ we have:

$$A_0 = \tau/T_0 = D$$

$$A_n = \frac{2\pi}{T_0} \frac{\sin\left(\pi n \frac{\tau}{T_0}\right)}{\pi n \frac{\tau}{T_0}} = 2D \frac{\sin(\pi n D)}{\pi n D}$$

$$B_n = 0$$

Being $T_0$ = 1/289.45 KHz, the 37th harmonics, that is 289.45 KHz*37 = 10.7095 MHz, falls inside the IF bandwidth (10.7 MHz). So, the 37th coefficient of the Fourier series must be 0 or close to it, which leads to sin($\pi$nD) = 0 or 37*$\pi$*D = k*$\pi$, or 37*D = k where k is any whole number. Hence we have to choose D = k/37. Being our time resolution 1/74.1 MHz we have D = $\delta$/256, with $\delta$ any integer number within the range 0< $\delta$<256. The best we can have is $\delta$ = 83, which leads $A_{37}/A_0$ = 2 sin (37*$\pi$*83/256)/(37*$\pi$), that is about -73 dB. Therefore, a preferable value for $\tau$ is $\tau$ = D*$T_0$ = $\delta$/256 *$T_0$ = (83/256)*(1/289.45 KHz).

Of course other values can be found which can still give good rejection at the disturbing harmonic, for example value of D comprised between D = 75/256 and D = 90/256.

The rejection can be easily further reduced by increasing $T_0$ by a multiple M of it, for example 10 times, so that we have to consider the 37*M harmonic

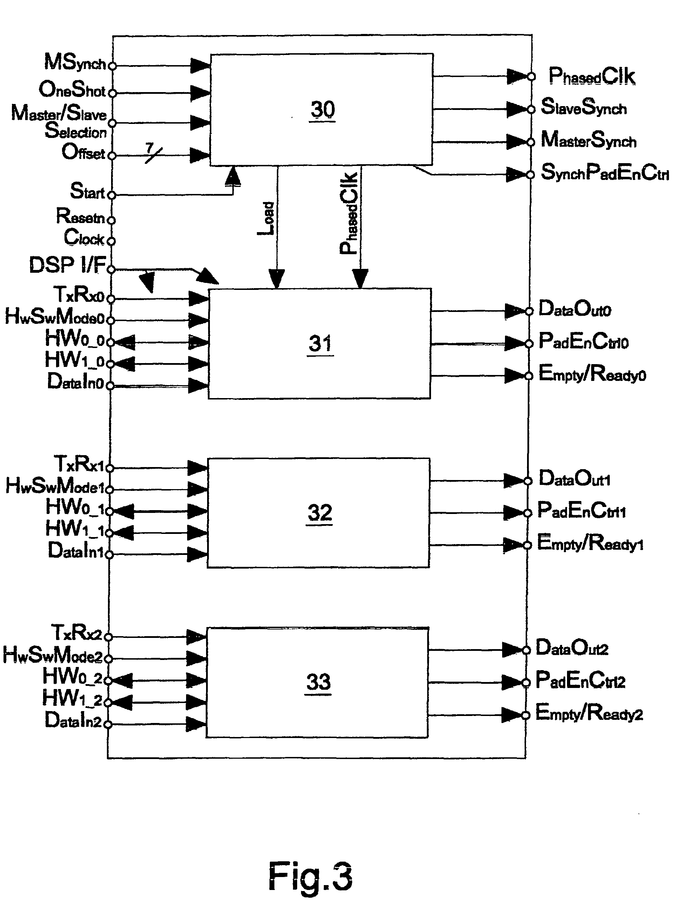

Refening now to figure 3, the interface can be petitioned in two main modules: the synchronisation signal manager 30, and the channel management blocks 31, 32, 33. It also contains the control status register (not shown), responsible for the set-up configuration of synchronisation and channel blocks

In this specification the channel management blocks 31, 32, 33 are three, but can be any number, i.e many blocks of the same kind can be placed more than once, provided the control status register contains enough bits for proper set-up configuration and data.

There are 2 main configurations of the interface, mutually exclusive

The master one: in this case the interface is responsible for synchronisation signal generation MSynch, and gives the proper duty cycle shaping.

The slave one: in this case the interface is responsible for recovery of the synchronisation from the reception of master synchronisation signal MSynch, and it also synchronises all the channel blocks of the slave. It can also be used for the slave interface synchronisation.

When in master mode a down-up counter counting from 0 to 255 by 1 step and clocked at 74.1MHz provides the basic waveform for the MSynch signal to be output as master to the slave. It is then shaped with an offset, selectable from external by a register in the range 1 to 127, of which resulting MSB is the Msynch (as aforesaid); the duty cycle is D=offset/256. The offset should be set as described above. Internally the data are handled in parallel, thus a parallel to serial in transmit mode, and serial to parallel in receive mode conversions are needed. The 8bit counter overflow is the load signal for the parallel to serial or serial to parallel conversion in the channel management block, which performs the conversion, and send/receive data to/from the electrical interface.

When in slave mode the clock divide by 8 samples the incoming MSynch (from external master) with four 90degrees off phase clocks at 9.26MHz frequency. It defines the window, where the MSynch has its rising edge. The clock phase selector selects one out of the four phases (clk0, clk90, clk180, clk270), to be used as slave clock in the channel managers (PhasedClk). It also provides a synchronisation pulse at 74.1MHz to synchronise the 8bit counter, and in turn the load operation, as well as a slave synchronisation to be used elsewhere in the slave interface (for instance to resynchronise the slave interface to the master one). The interface also has a reset from outside and needs a 74.1MHz system clock. A start signal is also available to synchronisation the interface when in master mode.

The synchronisation signal manager 30 has the one shot feature which enables the MSynch out just once in a 32bit data frame upon request. This is to have the quietest environment possible, where the synchronisation between the two interfaces is done just once for example at the very beginning, or upon request by software.

Here the serial in/out data are handled, together with the parallel to serial and serial to parallel interface. The write and read operation to data registers can be done either from digital signal processors or to/from an hardware block, hooked up to it.

Even in channel management block there are two main configurations of the channel.

The transmitter one: parallel data are read from digital signal processors or other block, and properly loaded into the 32bit register to be sent out serially at 9.26MHz rate.

The receiver one: the 32bit register serially reads in data from master, with proper re-phased 9.26MHz, then transferred to the digital signal processors register for parallel read from outside

The 32bit register is essentially a mono directional 32 bit shift register, which can be up-loaded either from parallel bus (from DSP registers for instance) or from serial line (DataIn in our case), hooked up to the first bit, or can download its contents to parallel registers or to the serial out line (DataOut).

The signals of the interface, according to the present invention, are the followings.

Inputs.

- Clock: system clock at 74.1MHz.
- Resetn: main reset of all the sequential circuitry. Active Low.
- Start: for resynchronisation of all counters and internal synchronisation signals.
- MSynch: in Slave mode, synchronisation signal from external Master interface.
- HW0_0, _1, _2: data input to last 16bit of sent/received serial data of respectively Channel Management Blocks 0, 1, 2.
- HW1_0, _1, _2: data input to first 16bit of sent/received serial data of respectively Channel Management Blocks 0, 1, 2.
- DataIn0, 1, 2: serial data in receiver mode. Outputs.
- PhasedClk: phased clock output, to be used externally as signal (e.g. test purposes).
- Slave Synch: 1 pulse at 74.1MHz frequency, to be used as external synchronisation in Slave mode.
- Master Synch: synchronisation output signal when in master mode, with duty cycle controllable.
- SynchPadEnCtrl: controls direction of the synchronisation output. High impedance when in slave mode, output when in master mode.
- DataOut0, 1,2: serial data out in transmitter mode.
- PadEnCtr10, 1, 2: gives direction to the InOut serial data pad, High impedance when in receiver mode, output when in transmitter mode.

Registers.

- DSPIF: data address interface (in/out) to the DSP core, for communication to it.
- Master/Slave Selection: bit which selects between Master (High) and Slave (Low). At reset it is Low (Slave).
- Offset: 7 bit value, which gives the offset for Master Synch output duty cycle. At reset equals 0.
- OneShot: when enabled, and in Master Mode the Master Synch is applied once in a data frame.
- TxRx0, 1, 2: for each block 1 bit select for transmitter (High), receiver (Low) mode. At reset is Low (Receiver).
- HwSwMode0, 1, 2: for each block 1 bit select for up/download from to either DSP (Low) or Hw block (High). At reset it is Low (DSP).

Preferably, the interface according to the present invention, as disclosed in figure 3, is carried out in a single chip.

The number of channels can be extended, since each channel management block is fully independent of each other. In a dual antenna diversity systems, the typical configuration is with master having two receiving channels (generally IF in phase and quadrature signals), and one transmitting channel, which is used for instructing the slave device.

**Claims**

1. Synchronous serial digital interface (16,17,19,20) for at least dual radio receiver systems comprising a master device (14) and a slave device (15),
said dual radio receiver systems having an intermediate frequency,
said master device and said slave device exchanging data in bi- , directional way on at least one communication channel (20),
said master device and said slave device having a unique bit clock;
said master device supplying to said slave device a synchronisation signal (19), **characterized in that**
said synchronisation signal has a duty cycle such that its frequency spectrum has an amplitude at said intermediate frequency which is lower than at the other frequencies.

2. Synchronous serial digital interface according to claim 1,
**characterized in that** said synchronisation signal have a duty cycle comprised between $D = 75/256$ and $D = 90/256$.

**3.** Synchronous serial digital interface according to claim 1,
**characterized in that** said slave device do not supply to said master device a synchronisation signal.

**4.** Synchronous serial digital interface according to claim 1,
**characterized in that** said master device receive the slave bit at the rising edge of the bit clock just after the one which has previously generated the master bit.

**5.** Synchronous serial digital interface according to claim 1,
**characterized in that** at the rising edge of said synchronisation signal start the transmission of data from said master device to said slave device.

**6.** Antenna diversity system for radio systems comprising a synchronous serial digital interface according to claim 1.

**Revendications**

**1.** Interface numérique série synchrone (16, 17, 19, 20) pour au moins des systèmes récepteurs radio doubles comprenant un dispositif maître (14) et un dispositif esclave (15),
lesdits systèmes récepteurs radio doubles ayant une fréquence intermédiaire,
ledit dispositif maître et ledit dispositif esclave échangeant des données de manière bidirectionnelle sur au moins une voie de communication (20),
ledit dispositif maître et ledit dispositif esclave ayant une horloge binaire unique ;
ledit dispositif maître délivrant au dit dispositif esclave un signal de synchronisation (19), **caractérisée en ce que** ledit signal de synchronisation a un rapport cyclique tel que son spectre de fréquences ait une amplitude à ladite fréquence intermédiaire qui est inférieure aux autres fréquences.

**2.** Interface numérique série synchrone selon la revendication 1, **caractérisée en ce que** ledit signal de synchronisation a un rapport cyclique compris entre D = 75/256 et D = 90/256.

**3.** Interface numérique série synchrone selon la revendication 1, **caractérisée en ce que** ledit dispositif esclave ne délivre pas au dit dispositif maître un signal de synchronisation.

**4.** Interface numérique série synchrone selon la revendication 1, **caractérisée en ce que** ledit dispositif maître reçoit le bit esclave au front montant de l'horloge binaire juste après celui qui a précédemment généré le bit maître.

**5.** Interface numérique série synchrone selon la revendication 1, **caractérisée en ce que**, au front montant dudit signal de synchronisation commence la transmission de données dudit dispositif maître au dit dispositif esclave.

**6.** Système de diversité d'antenne pour systèmes radio comprenant une interface numérique série synchrone selon la revendication 1.

**Patentansprüche**

**1.** Synchrone serielle Digitalschnittstelle (16) für zumindest Zweifachfunkempfängersysteme mit einer Master-Vorrichtung (14) und einer Slave-Vorrichtung (15),
wobei die Zweifachfunkempfängersysteme eine Zwischenfrequenz aufweisen,
die Master-Vorrichtung und die Slave-Vorrichtung Daten auf bidirektionale Weise auf zumindest einem Kommunikationskanal austauschen,
die Master-Vorrichtung und die Slave-Vorrichtung einen einzelnen Bittakt haben,
die Master-Vorrichtung an die Slave-Vorrichtung ein Synchronisationssignal liefert,
**dadurch gekennzeichnet, dass**
das Synchronisationssignal so ein Tastverhältnis aufweist, dass sein Frequenzspektrum bei der Zwischenfrequenz eine Amplitude aufweist, die kleiner ist als bei den anderen Frequenzen.

**2.** Synchrone serielle Digitalschnittstelle nach Anspruch 1, **dadurch gekennzeichnet, dass** das Synchronisationssignal ein Tastverhältnis aufweist, das zwischen D=75/256 und D=90/256 liegt.

**3.** Synchrone serielle Digitalschnittstelle nach Anspruch 1, **dadurch gekennzeichnet, dass** die Slave-Vorrichtung an die Master-Vorrichtung kein Synchronisationssignal liefert.

**4.** Synchrone serielle Digitalschnittstelle nach Anspruch 1, **dadurch gekennzeichnet, dass** die Master-Vorrichtung das Slave-Bit empfängt bei der ansteigenden Flanke des Bittakts gleich nach derjenigen, die vorher das Masterbit erzeugt hat.

**5.** Synchrone serielle Digitalschnittstelle nach Anspruch 1, **dadurch gekennzeichnet, dass** bei der ansteigenden Flanke des Synchronisationssignals die Übertragung von Daten von der Master-Vorrichtung an die Slave-Vorrichtung beginnt.

**6.** Antennendiversitysystem für Funksysteme mit einer synchronen seriellen Digitalschnittstelle nach Anspruch 1.

Fig.1

Fig.2

Fig.3